(19) Europäisches Patentamt
European Patent Office
Office européen des brevets

(11) **EP 4 730 041 A1**

(12) **EUROPEAN PATENT APPLICATION**

(43) Date of publication:
**22.04.2026 Bulletin 2026/17**

(21) Application number: 25209811.6

(22) Date of filing: **20.10.2025**

(51) International Patent Classification (IPC):
***G03F 7/40*** *(2006.01)*

(52) Cooperative Patent Classification (CPC):
**G03F 7/40**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **21.10.2024 IT 202400023406**

(71) Applicant: **Vianord Engineering Sasu 06510 Carros (FR)**

(72) Inventor: **SASSANELLI, Pier Luigi 06800 Cagnes-sur-Mer (FR)**

(74) Representative: **De Bortoli, Tiziano et al Zanoli & Giavarini SpA Via Melchiorre Gioia, 64 20125 Milano (IT)**

(54) **METHOD FOR DRYING A DIGITAL PRINTING PLATE FOR FLEXOGRAPHY**

(57) The present invention relates to a method for drying a flexographic plate (5) previously subjected to washing with a water-based or solvent-based liquid. The method according to the invention involves providing a support member (10) made of a thermo-conductive material, wherein said support member (10) comprises at least a first main surface (10A) adapted to allow the support of said plate (5) to be dried. The method involves positioning the plate (5) to be dried on the support element (10) so that a base face (5A) of the plate rests on said first main surface (10A). The method further provides the step of heating, by means of thermal energy generating means (100), said support element (10) to a preestablished temperature so that the thermal energy supplied to said support element (10) is transferred by conduction to said plate (5) resting on said support element (10) so as to cause evaporation of residual liquid contained in said plate. The invention also relates to an apparatus for carrying out a drying method according to the invention.

FIG. 2

EP 4 730 041 A1

**Description**

FIELD OF THE INVENTION

The present invention relates to the technical field of the manufacturing of apparatus and systems for the preparation of digital printing plates for flexography. In particular, the present invention relates to a method for drying a flexographic plate. Such method is implemented following a washing operation of the flexographic plate carried out with a solvent-based or water-based liquid. The present invention also relates to an apparatus for carrying out the method according to the invention.

BACKGROUND ART

Flexography, also known as flexo, is a direct rotary printing method that uses relief matrices made from photopolymer materials. These matrices, called printing plates, are of a flexible and soft type. They are wound onto a printing cylinder, or pressure cylinder, and inked. Printing is obtained by directly depositing ink on the substrate to be printed by means of a light pressure exerted by said cylinder on said printing substrate.

Flexography is a high-speed printing process which may be used to print on various types of substrates, made of both absorbent and non-absorbent material. Flexographic printing was initially used to make paper and plastic bags, milk cartons, disposable cups and the like. However, thanks to improved printing features, this technology is now also used for printing newspapers, envelopes, labels, as well as printing on plastic, films, acetate sheets, wrapping paper and many other materials used in packaging.

In order to obtain good print quality, it is essential to take care of the preparation of the flexographic plate in detail. This preparation comprises several steps including: a step of exposure of the plate to ultraviolet (UV) light, aimed at its photopolymerization, a subsequent washing step, a drying step aimed at eliminating the solvent or water used during the washing step and finally a finishing step with ultraviolet light (UVA and UVC).

To obtain the raised characters, the plate is polymerized only at specific portions of a light-impermeable mask, which have previously been made permeable to light. In particular, in the case of analog printing plates, a film is applied to the plate which reproduces, in negative, the image to be printed. In this case, the film acts as a mask. While, in the case of digital printing plates, the photopolymer is initially covered by a surface layer of opaque material, i.e. a material impermeable to light, such as graphite. In this case, this surface layer acts as a mask and is therefore etched so as to create the negative of the image to be printed. The engraving step is usually done using a computer-controlled digital laser.

Exposing the plate to light causes the polymerization of only those parts of the plate located at the portions of the mask permeable to light, thus forming the image to be printed in relief on the photopolymer.

Currently, such photoexposure step is carried out using conventional UV lamps or using LED lamps, as described for example in patent documents WO 2013/156942 A1, US 2016/0229173 A1 and EP 3121653 B1. The exposure time to light varies according to the intensity of the power radiated per unit of time and, secondarily, according to the thickness of the plate.

Subsequently, the flexographic plate is subjected to a washing step aimed at removing the portions of material that have not been exposed to light and are therefore not polymerized. Such step may be carried out using a solvent which, penetrating the polymer, dissolves the unpolymerized portions, or using water which causes the unpolymerized portions to detach, which are then removed using special brushes. As an alternative to solvent washing and water washing, a washing of thermal type may be used.

Subsequently, the flexographic plate is subjected to drying, aimed at removing the water or solvent absorbed by the plate during the washing step. Downstream of drying, a finishing step is generally provided, in which the flexographic plate is subjected to a finishing treatment which typically involves exposing the flexographic plate to a plurality of neon lamps that emit UV-A and/or UV-C radiation.

The drying step is typically carried out in an apparatus *(also called dryer)* comprising a plurality of drawers in each of which the slab is placed. Drying is achieved through heat exchange between the plate and hot air that touches the surface of the plate previously developed through the washing operation. In particular, hot air is circulated in the drawers through fans and is heated by lamps *(typically with quartz resistors)* positioned inside the device. An example of an apparatus and method for drying a flexographic plate is described in WO 2005/121898.

The known apparatuses based on this principle have several critical aspects, the main one of which is the long operating times. The evaporation of the liquid *(water-based or solvent-based)* absorbed by the plate is a slow process that occurs from the bottom up. This process is hindered by the humidity that accumulates in the warm air circulating in the drawers due to evaporation itself. The forced circulation of hot air and the high humidity level cause uneven drying, meaning some areas of the slab dry before others.

Because of this, overall drying times currently stand at around 2-4 hours. This obviously has a significant impact on energy consumption related to the lamps and fans needed to circulate hot air.

Another drawback of traditional apparatuses is the need to preheat the drawers before placing the plates to be dried in the drawers themselves. This aspect also obviously has a negative impact in terms of energy consumption.

A further drawback is the difficulty in precisely controlling the temperature inside the drawers to avoid possible distortion of the plate *(in particular due to the presence of a layer of mylar at its base)* which could occur when this temperature exceeds 70C°. For this purpose, a thermostat is normally used that activates/deactivates the electrical resistors of the lamps which, as is known, may reach temperatures of several hundred degrees. Furthermore, the same type of problem occurs when, even if the temperature measured by the thermostat is within the permitted limits of 65°C, the temperature reached by the plate during drying is not sufficiently uniform across its entire surface.

In light of these considerations, the need for a new drying apparatus and a new drying method clearly emerges, which allow the above-mentioned drawbacks to be eliminated or reduced to a minimum.

SUMMARY

The task of the present invention is therefore to provide a method and apparatus for drying digital flexographic plates which allows the above-mentioned drawbacks to be overcome or at least mitigated.

Within this task, a first object is to provide a drying method that allows for a significant reduction in operating times compared to those currently permitted by traditional methods and apparatuses.

Another object of the present invention is to provide a drying method that allows energy savings compared to the apparatuses currently used.

Yet another object is to provide a drying method which is reliable and easy to manufacture at competitive costs.

A further object of the present invention is to provide a method for drying a flexographic plate applicable in a stand-alone apparatus or in an apparatus inserted in an in-line system for the preparation of flexographic plates.

Not least, an object is to provide a drying method which is reliable and easy to implement at competitive costs.

The Applicant has found that the above-mentioned task and objects can be achieved by providing a support element for the plate made of heat-conducting material and by heating, directly or indirectly, such support element. In this way, the evaporation of the solvent occurs as a result of heat exchange by conduction between the flexographic plate and the support element heated by a thermal energy generating means.

In particular, the Applicant has found that the above-mentioned task and objects are achieved through a method as set forth in Claim 1. The dependent claims specify preferred embodiments of the method according to the invention.

More in detail, the above-mentioned task and objects are achieved by a method for drying a flexographic plate, wherein said plate to be dried comprises a base face and a developed face opposite to said base face, wherein said method comprises the steps of:

> a) providing a support member made of a thermoconductive material, wherein said support member comprises at least a first main surface for supporting said plate to be dried;
> b) positioning said plate to be dried on said support element so that said base face rests on said first main surface;
> c) heating, by means of thermal energy generating means, said support element to a preestablished temperature so that the thermal energy supplied to said support element is transferred to said plate resting on said support element and causes evaporation of residual liquid contained in said plate to be dried.

According to a possible embodiment, said *step (c)* is carried out following completion of said *step (b)* or said *step (c)* is carried out before said *step (b)* or wherein said *step (c)* is carried out concurrently with said *step (b)*.

According to a possible embodiment, said predetermined temperature is below 75 C°. According to a possible embodiment, in said step b) said plate is positioned so that said base face is in direct thermal contact with said first main surface of said support element. According to a possible embodiment, said thermal energy generating means is at least partially integrated with said support element, wherein preferably said thermal energy generating means comprises an electrical resistance or an infrared heating cable.

According to another possible embodiment, the thermal energy generating means comprises a screen-printed resistor sheet, which is applied to the second main surface of the support element.

Preferably, such screen-printed resistor sheet is sandwiched between the support element and a layer made of insulated material and the insulated layer is sandwiched between the screen-printed resistors sheet and a closing layer so as to obtain a layered structure.

According to a possible embodiment, a plurality of such layered structures is placed adjacent to each other, and the screen-printed resistor sheets of adjacent layered structures are electrically connected by means of electrical connectors

According to a possible embodiment, said method comprises the step of determining a circulation of air above said developed face of said plate when said plate rests on said support element.

According to a possible embodiment, the method comprises the step of positioning said support element inside a drying chamber kept closed when said *step c)* is carried out and when said plate rests on said support element.

According to a possible embodiment, said method further comprises the step of determining an air circulation above said developed face of said plate subsequently said *step b)* and/or extracting evaporation products from said drying chamber when said step c) is carried out and when said plate rests on said support element.

The present invention also relates to an apparatus for carrying out the method according to the invention. In particular, such apparatus comprises at least one drying chamber in which said support element and said thermal energy generating means are positionable.

LIST OF FIGURES

Further features and advantages of the present invention will become clearer from the description of preferred, but non-exclusive, embodiments of a drying method according to the invention, as well as of a drying apparatus, illustrated by way of example in the accompanying drawings, in which:

- Figure 1 is a schematic view relating to some steps of a method according to the invention;
- Figures 1A and 1B are explanatory detailed views of the structure of a flexographic plate to be dried and of a support element for implementing a method according to the invention;
- Figures 2 to 5 are further schematic views relating to steps of a method according to the invention;
- Figure 6 is a schematic view relating to a possible embodiment of a method according to the invention;
- Figure 7 is a schematic view of a drying apparatus for carrying out the method according to the invention.

The same reference numerals and letters in the figures identify the same elements or components.

DETAILED DESCRIPTION OF EMBODIMENTS OF THE INVENTION

With reference to the above figures, the present invention therefore relates to a method for drying a flexographic plate 5 *(or plate* 5) previously developed through washing with a solvent-based or water-based liquid. For the purposes of the present invention, the plate 5 is of a known type typically comprising a first face 5A *(or base face 5A)* and a second face 5B *(or developed face 5B)* opposite to said first face 5A. The distance between the two faces 5A and 5B defines the thickness of the plate 5. Typically, the plate 5 has a rectangular shape. The method according to the invention comprises a first step *(hereinafter also referred to as step a))* which involves providing a support element 10, made of heat-conducting material, suitable for supporting said plate 5. In particular, such support element 10 comprises a flat part and is made of aluminium or other heat-conductive material. This plate-shaped part of the element 10 defines a first main surface 10A on which the plate 5 to be dried is intended to rest.

The method according to the invention includes second step *(hereinafter referred to as step* b)), subsequent to the first, which involves positioning the plate 5 on the support element 10, in particular so that the base face 5A of the plate 5 rests on the first main surface 10A of the support element 10. Preferably, the plate 5 is positioned so that the base face 5 is also in direct thermal contact with the first main surface 10A of the support member 10. Alternatively, an interface layer/element may be positioned between the plate 5 and the support element 10 so that the plate 5 rests indirectly on the support element 10. Any interface layer/element will be made of a thermally non-insulating material.

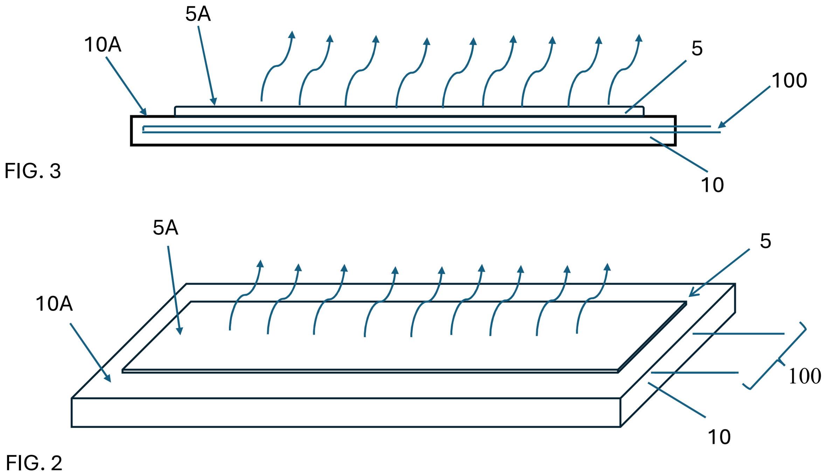

The method according to the invention includes at least one further step *(hereinafter also referred to as step c))* of heating the support element 10 until it reaches a pre-established temperature. This heating occurs through a means 100 for generating thermal energy *(i.e. heat).* The thermal energy, supplied to the support element 10, is therefore transferred by conduction to the plate 5 resting on the first main surface 10A of the support element 10. In practice, the thermal energy/heat produced by the generation means 100 is first transferred, directly/or indirectly, to the support element 10 and subsequently by conduction, through the same support element 10, to the base face 5A of the plate 5. This thermal energy produces the evaporation *(schematically indicated by curved arrows in Figures 2 to 5)* of the residual liquid *(water or solvent)* contained in the plate 5 and absorbed during the washing step to which the plate was previously subjected.

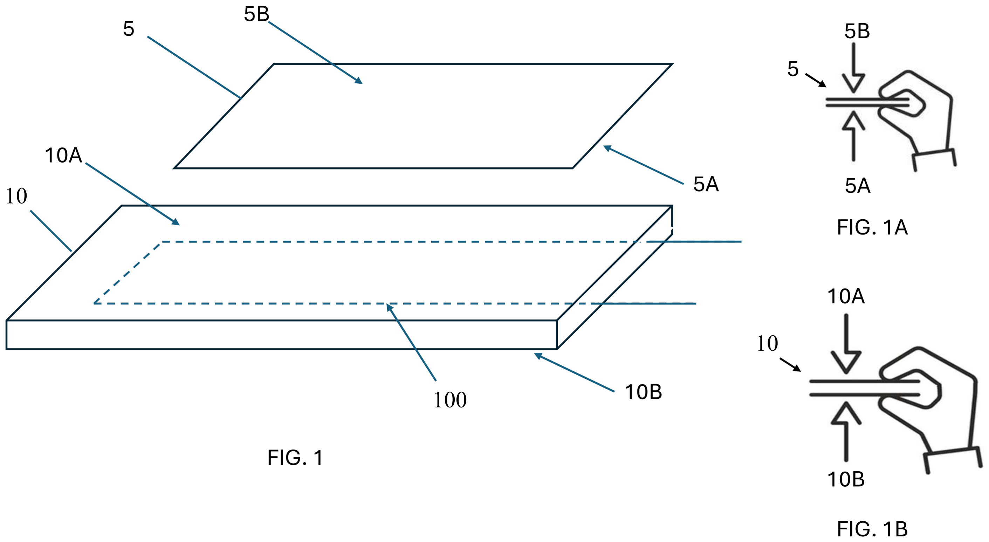

Therefore, according to the invention, the transferred thermal energy reaches the inside of the plate 5 starting from its base face 5A. This principle is contrary to what is expected in known solutions in which the thermal energy reaches the inside of the plate through the developed face *(5B in Figure 1A),* where the latter is heated by thermal convection with hot air.

The support element 10 is heated to a pre-established temperature, in any case lower than 75°C in order to avoid damaging the Mylar layer *(or other equivalent material)* typically provided in the plate 5 to increase its mechanical resistance.

Preferably, the support element 10 is defined by a flat plate made of metal material *(schematized in the figures).* Therefore, a second main surface 10B is identified opposite to said first main surface 10A, where the distance between said main surfaces 10A, 10B establishes the thickness of the flat plate *(i.e. of the support element 10),* as can be clearly seen for example from Figure 1B. Preferably, said flat plate has a rectangular shape, where the extension of the two main surfaces 10A, 10B is greater than or equal to the extension of the main surfaces 5A, 5B of the flexographic plate 5 to be dried.

According to a possible preferred embodiment of the invention, the thermal energy generating means 100 is at least partially integrated into the support element 10. The term *"integrated"* is used to indicate a condition whereby the heat generation means is integral with the support element 10, i.e. included *(completely or partially)* or connected to the support element 10.

In this regard, one or more electrical resistances in thermal contact with the support element 10 may be used as a thermal energy generating means 100. In particular, such electrical resistance(s) may be embedded *(completely or partially)* in the support element 10 as shown schematically in Figures 2 and 3.

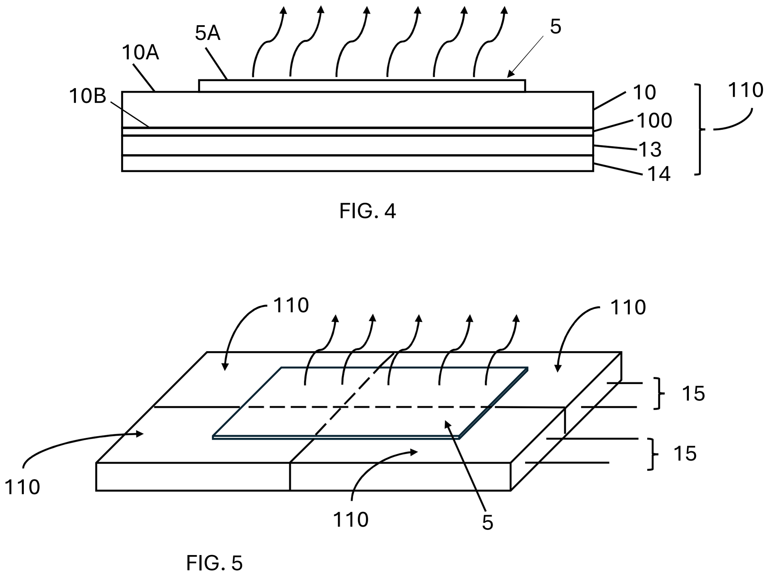

According to an alternative embodiment, shown in Figures 4 and 5, the thermal energy generating means consists of a sheet 100 *(hereinafter also referred to as screen-print resistor sheet 100)* provided with resistors, which are deposited on the sheet 100 using a screenprinting process.

The screen-printed resistor sheet 100 is preferably made of ceramic, for example alumina *(or any other suitable insulating material)* and the resistors are made of metal oxide-based paste or conductive inks, such as silver, carbon, or nickel-chromium, and are printed on the sheet 100 as thin, sinuous tracks *(or serpentines),* lines or spirals, to increase the path length and therefore the resistance.

The screen-printed resistor sheet 100 is applied, for example glued, to the second main surface 10B of the support element 10 and is preferably sandwiched between the support element 10 and a layer 13 made of insulated material. Preferably, the insulated layer 13 is in turn sandwiched between the screen-printed resistor sheet 100 and a closing layer 14, preferably made of metal material. A layered structure 110 is thus obtained, which comprises the support element 10, the screen-printed resistor sheet 100, the insulated layer 13 and the closing layer 14.

It is possible to foresee a single layered structure 110, as shown in Figure 4, or a plurality of layered structures 110 adjacent to each other, as shown in Figure 5. In this latter case, the screen-printed resistor sheets 100 are provided with connectors 15 for electrical connection with the screen-printed resistor sheet 100 of one or more adjacent layered structures 110.

According to an alternative embodiment, an infrared heating cable may be used as the thermal energy generating means 100, whereby such heating cable is placed in thermal contact with the support element 10, preferably at its second main surface 10B. Alternatively, the infrared heating cable may be located at a position spaced from said second main surface 10B so as to heat the support member 10 by radiation.

In any case, a voltage generator 90 *(or electrical source 90)* will be provided to which the ends of the electrical resistance or heating cable *(i.e. of the generating means 100)* will be connected to generate the necessary electrical current, i.e. to generate the thermal energy to be transferred firstly to the support element 10 and subsequently to the plate 5 to be dried, by conduction through the same support element 10.

In any case, the thermal energy generating means 100 is a heating means configured to rapidly bring the support element 10 to the pre-set temperature and maintain this temperature until the evaporation of the liquid contained in the plate 5 is completed. The plate 5 can therefore be dried at a constant temperature and therefore uniformly and in short times.

With an infrared heating cable, for example, the generated thermal power Q and the temperature T of the cable itself reach their respective maximum peaks in a few seconds, stabilising at predefined maximum power and temperature values, *Qmax* and *Tmax* respectively. In mathematical terms, the above translates into the following formula:

$$Qmax = (V * V)/(L * R)$$

where *V* is the voltage applied to the heating cable, *L* is the length of the infrared heating cable, and R is the resistance of the heating cable. The heating cable can therefore be specifically calibrated so as to be able to reach only the maximum temperature *Tmax,* specifically 60°C -65°C defined during the manufacturing step. The maximum temperature *Tmax* of the heating cable is a function of the cable resistance and the applied voltage. The resistance R is instead a function of the length L of the cable. Therefore, by applying a certain voltage to a given resistance, the maximum achievable temperature can never be exceeded. A predefined voltage is applied to the calibrated infrared heating cable, which can be for example 12VDC, 24VDC, 110VAC or 230VAC.

According to a possible embodiment, *step c)* of the method according to the invention is carried out at concurrently or subsequently *step b),* i.e. following the positioning of the plate on the support element 10. According to a preferred embodiment, to accelerate the drying of the plate 5, *step c)* can be carried out before *step b).* In this way, as soon as the plate 5 is positioned on the support element 10, the thermal conduction between the two elements *(plate 5 and support element 10)* is maximized to the advantage of a reduction in the times required for drying.

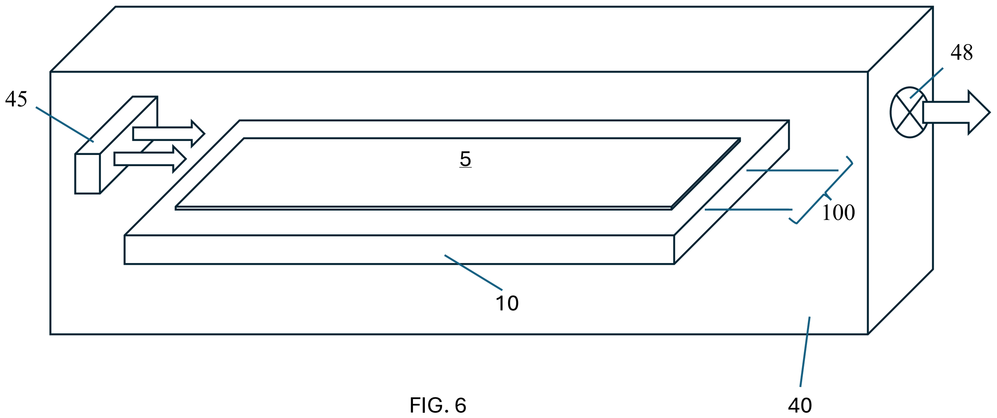

With reference to Figure 6, preferably, the method according to the invention also includes the step of arranging the support element 10 inside a drying chamber 40 *(hereinafter chamber 40).* In particular, the latter is kept closed during the execution of *step c)* following *step b),* i.e. during the heating of the support element 10 *(i.e. until the evaporation of the solvent is completed)* on which the plate 5 rests.

According to a possible embodiment, the support element 10 can be inserted into the chamber 40 before positioning the plate 5 on the same support element 10 *(i.e. before carrying out step b).* Alternatively, the support element 10 can be inserted into the chamber 40 together with the plate 5, i.e. with the latter already resting on the second main surface 10B of the support element 10.

The method according to the invention preferably comprises a further step which provides air circulation above the developed surface 5B of the plate 5 while heating the support element 10. When the plate 5 is inserted inside the chamber 40, air circulation can be obtained through a fan 45 or another functionally equivalent means. In particular, air circulation is kept active at least throughout the entire drying step *(step c)*.

Still in the case of positioning inside the chamber 40, preferably, the method also comprises the further step which consists in extracting, from the chamber 40, the evaporation products *(or evaporation fumes)* which are generated during *step c)*. A suction fan 48 or other functionally equivalent suction means can be used for extracting fumes.

Preferably, this fume extraction step is carried out for the entire duration *of step c)*. Even more preferably, the fume extraction step is activated before carrying out step c), maintained for the entire duration of step c) and for a predetermined period of time following the completion of step c).

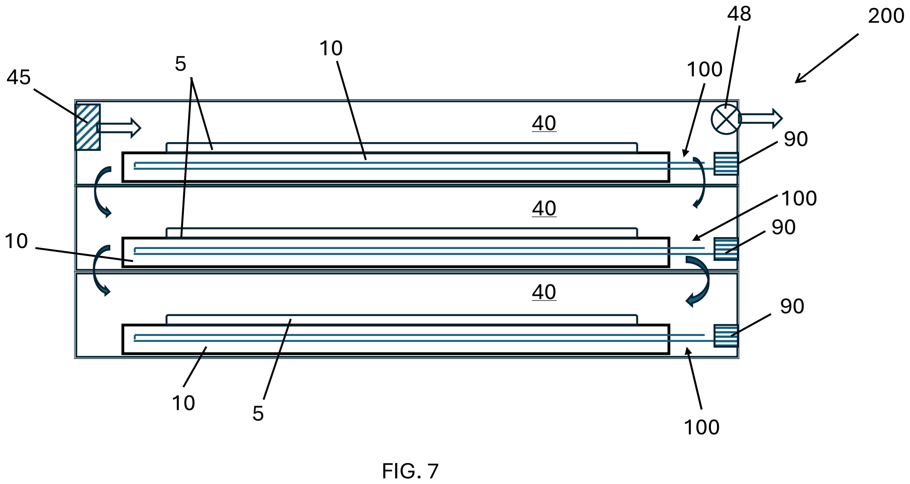

The present invention also relates to an apparatus 200 for drying a flexographic plate 5, wherein such apparatus is configured to carry out the method according to the invention. The apparatus 200 according to the invention comprises at least one drying chamber 40 in which a support element 10 for a drying plate 5 can be positioned, where said support element 10 is connected to a heating means 100 which, when activated, allows it to be heated to a predetermined temperature. Preferably, as schematized in Figure 7, the apparatus 200 comprises a plurality of drying chambers 40 *(for example in the form of drawers)* in each of which a support element 10 can be positioned for a plate 5 to be dried, where each support element 10 is connected to a heating means 100 which allows it to be heated to a pre-established temperature.

The support element 10 and the heating means 100 may therefore have conformations such as those described above. In this regard, in the case in which the heating means 100 is an electric resistance, a screen-printed resistor sheet 100 or an infrared heating cable, for each drying chamber 40 the apparatus will comprise an electric power source 90 to which the generator means 100 will be connected, at least when the related support element 10 is operatively positioned in the chamber itself.

In a possible embodiment, the support element 10 may be extractable *(like a drawer)* with respect to the relative chamber 40 to facilitate the positioning and removal of the plate 5. In an alternative embodiment, the support element 10 may be removable and movable with respect to the chamber 40, i.e. it may be completely inserted and subsequently completely extracted from the chamber 40. In this embodiment, the chamber 40 may comprise an inlet port for the insertion of the support element 10 *(on which the plate 5 to be dried has already been positioned)* and an outlet port for the same support element 10 *(on which the dried plate is located)*. During drying, these doors *(inlet and outlet)* are intended to remain closed. This last embodiment could be used in an in-line plant for the preparation of flexographic plates, in which the drying apparatus 200 is placed downstream of a washing apparatus and upstream of a plate finishing apparatus.

According to a possible embodiment shown schematically in Figure 6, the chambers 40 could be connected in order to create a common air circulation *(shown schematically by the curved arrows in Figure 7)*. In this case, a fan 45 *(or equivalent means)* could be used to cause air circulation in multiple chambers *(or even in all chambers)*. Similarly, a single fan 48 could be used to extract evaporation fumes generated in multiple chambers.

Alternatively, an air circulation fan 45 could be provided for each chamber 40. Similarly, for each chamber 40 a fan 48 could be provided to extract evaporation fumes.

As can be seen from the description, the method and apparatus according to the present invention allow to fully fulfil the intended tasks and objects. In particular, the method according to the invention allows for more uniform and more controllable drying than that permitted by traditional solutions based on the use of heating lamps. Furthermore, the method according to the invention allows for a significant reduction in drying times as well as a significant reduction in energy costs. All to the advantage of greater productivity.

The drying method and apparatus, thus conceived, lend themselves to numerous possible variations, all of which fall within the scope of the present invention. The materials used, as well as the dimensions and contingent shapes, may be any according to needs and the state of the art.

**Claims**

1.  Method for drying a flexographic plate (5), wherein said plate (5) to be dried comprises a base face (5A) and a developed face (5B) opposite to said base face (5A), wherein said method comprises the steps of:

    a) providing a support member (10) made of a thermo-conductive material, wherein said support member (10) comprises at least a first main surface (10A) for supporting said plate (5) to be dried;
    b) positioning said plate (5) to be dried on said support element (10) so that said base face (5A) rests on said first main surface (10A);
    c) heating, by means of thermal energy generating means (100), said support element (10) to a preestablished temperature so that the thermal energy supplied to said support element (10) is transferred to said plate (5) resting on said support element (10) and causes evaporation of residual liquid contained in said plate (5) to be dried.

**2.** Method according to claim 1, wherein said *step (c)* is carried out following completion of said *step (b)* or wherein said *step (c)* is carried out before said *step (b)* or wherein said *step (c)* is carried out concurrently with said step (b).

**3.** Method according to claim 1 or 2, wherein said predetermined temperature is below 75 C°.

**4.** Method according to any of the preceding claims, wherein in said step b) said plate (5) is positioned so that said base face (5A) is in direct thermal contact with said first main surface (10A) of said support element (10).

**5.** Method according to any of the preceding claims, wherein said thermal energy generating means (100) is at least partially integrated with said support element (10).

**6.** Method according to claim 5, wherein said thermal energy generating means (100) comprises an electrical resistance or an infrared heating cable.

**7.** Method according to any claims 1 to 4, wherein the thermal energy generating means (100) comprises a screen-printed resistor sheet (100), which is applied to the second main surface (10B) of the support element (10).

**8.** Method according to claim 7, wherein the screen-printed resistor sheet (100) is sandwiched between the support element (10) and a layer (13) made of insulated material and the insulated layer (13) is sandwiched between the screen-printed resistors sheet (100) and a closing layer (14) to obtain a layered structure (110).

**9.** Method according to claim 7, wherein a plurality of layered structures (110) is placed adjacent to each other and the screen-printed resistor sheets (100) of adjacent layered structures (110) are electrically connected by means of electrical connectors (15).

**10.** Method according to any one of claims 1 to 9, wherein said method comprises the step of determining a circulation of air above said developed face (5B) of said plate (5) when said plate rests on said support element (10).

**11.** Method according to any one of claims 1 to 10, wherein said method comprises the step of positioning said support element (10) inside a drying chamber (40) kept closed when said *step c)* is carried out and when said plate (5) rests on said support element (10).

**12.** Method according to claim 11, wherein said method further comprises the step of determining an air circulation above said developed face (5B) of said plate (5) subsequently said *step b)* and/or extracting evaporation products from said drying chamber (40) when said step c) is carried out and when said plate (5) rests on said support element (10).

**13.** Drying apparatus (200) for carrying out the method according to any one of claims 1 to 12, wherein said apparatus (200) comprises at least one drying chamber (40) in which said support element (10) and said thermal energy generating means (100) are positionable.

FIG. 1A

FIG. 1B

FIG. 1

FIG. 3

FIG. 2

EP 4 730 041 A1

FIG. 4

FIG. 5

EP 4 730 041 A1

FIG. 6

FIG. 7

Europäisches
Patentamt

European
Patent Office

Office européen
des brevets

## EUROPEAN SEARCH REPORT

**Application Number**

EP 25 20 9811

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | EP 1 605 309 A1 (DEGRAF S P A [IT]) 14 December 2005 (2005-12-14) | 13 | INV. G03F7/40 |
| A | * paragraphs [0001], [0014]; claims 1-25; figures 1-4 * | 1-12 | |
| | ----- | | |
| X | CN 220 933 345 U (GUANGDONG ROUYIN MACHINERY CO LTD) 10 May 2024 (2024-05-10) | 13 | |
| A | * the whole document * | 1-12 | |
| | ----- | | |

**TECHNICAL FIELDS SEARCHED (IPC)**

G03F

The present search report has been drawn up for all claims

| Place of search | Date of completion of the search | Examiner |
|---|---|---|
| Munich | 16 February 2026 | Borowczak, Baptiste |

EPO FORM 1503 03.82 (P04C01)

## ANNEX TO THE EUROPEAN SEARCH REPORT
## ON EUROPEAN PATENT APPLICATION NO.

EP 25 20 9811

This annex lists the patent family members relating to the patent documents cited in the above-mentioned European search report.
The members are as contained in the European Patent Office EDP file on
The European Patent Office is in no way liable for these particulars which are merely given for the purpose of information.

16-02-2026

| Patent document cited in search report | | Publication date | Patent family member(s) | | Publication date |
|---|---|---|---|---|---|
| EP 1605309 | A1 | 14-12-2005 | AT | E395633 T1 | 15-05-2008 |
| | | | CA | 2569777 A1 | 22-12-2005 |
| | | | EP | 1605309 A1 | 14-12-2005 |
| | | | EP | 1766477 A1 | 28-03-2007 |
| | | | US | 2006130688 A1 | 22-06-2006 |
| | | | WO | 2005121898 A1 | 22-12-2005 |
| CN 220933345 | U | 10-05-2024 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013156942 A1
- US 20160229173 A1
- EP 3121653 B1
- WO 2005121898 A